# EUROPEAN PATENT SPECIFICATION

(11) **EP 2 839 904 B1**
(45) Date of publication and mention of the grant of the patent: **16.12.2020**
(21) Application number: 14275173.4
(22) Date of filing: 19.08.2014
(51) Int. Cl.: B22F 1/00, C22C 9/00, C22C 9/02, C22C 12/00, C22C 13/00, C22C 13/02, H01L 21/768, H01L 23/00, H01L 23/48

(54) **Functional material**
Funktionelles Material
Matériau fonctionnel

(30) Priority: 21.08.2013 JP 2013171259
(43) Date of publication of application: 25.02.2015
(73) Proprietor: Napra Co., Ltd., Katsushika-Ku Tokyo 124-0013 (JP)
(72) Inventor: Sekine, Shigenobu, Katsushika-Ku, Tokyo 124-0013 (JP); Sekine, Yurina, Katsushika-Ku, Tokyo 124-0013 (JP)
(74) Representative: Potter Clarkson

(56) References cited:
- WO-A1-2013/038817
- JP-A- 2002 198 654
- JP-A- 2004 363 052
- JP-B- 5 124 693
- US-A1- 2010 252 616
- US-A1- 2012 211 549

## Description

### BACKGROUND OF THE INVENTION

### 1. Field of the Invention

The present invention relates to a functional material. The term "functional material" as used herein refers to a material which can serve a desired function based on its inherent properties such as electrical properties, dielectric properties, magnetic properties, optical properties, bonding properties or sealing properties. The functional material according to the present invention can be used as a wiring material, an electrode material, a filling material, a sealing material or a bonding material.

### 2. Description of the Related Art

As a means for realizing a three-dimensional circuit configuration in electronic devices such as various scales of integrated circuits, various types of semiconductor elements or chips thereof, there has been proposed a TSV (through-silicon-via) technology of providing a circuit substrate with a large number of through electrodes and stacking such circuit substrates. By applying the TSV technology to the three-dimensional circuit configuration, many functions can be packed into a small footprint. Moreover, important electrical pathways between elements can be dramatically shortened to increase processing speed. Japanese Patent No. 3869859 discloses a via hole structure essential for the TSV technology.

The via hole structure disclosed in Japanese Patent No. 3869859 must contain a binder and/or a reactive monomer or polymer in addition to a high melting point metal, a low melting point metal or metal alloy and a crosslinking agent. In a cured state within a via hole, a polymeric network generated by crosslinking of organic constituents of a conductive adhesive coexists with an alloyed metal network.

After the via hole structure disclosed in Japanese Patent No. 3869859 is cured within the via hole, the polymeric network coexists with the alloyed metal network, as described in its specification. This degrades electrical conductivity accordingly.

Also, there is a problem inherent in diffusion bonding of metal, i.e., the formation of voids, cracks or the like due to Kirkendall voids. Kirkendall voids arise as atomic vacancies (lattice), which arise from the asymmetry of interdiffusion, accumulate without disappearing. In the case of a Sn/Cu interface, for example, since Sn diffuses less than Cu, the vacancies accumulate at the interface between the intermetallic compound and Cu, thereby forming Kirkendall voids. Such Kirkendall voids may grow into a larger void or crack, deteriorating the reliability or quality of electrodes and therefore causing disconnection. Japanese Patent No. 3869859 does not disclose any countermeasure against this problem.

A similar problem arises when a wiring planar conductive pattern is formed on a surface of a wafer along with or independently of through electrodes, when semiconductor chips are connected to each other in an electronic device, e.g., in the form of three-dimensional system-in-package (3D-SiP), or when sealing is performed in a liquid crystal device or the like.

JP 5 124693 B discloses an electronic device comprising a substrate and an electronic component. The substrate has a metallization trace having a metallization layer and a synthetic resin layer. The metallization layer has a high-melting-point metallic component and a low melting-point metallic component. The high-melting-point metallic component and the low melting-point metallic component are diffusion bonded together and adhered to a surface of the substrate. The synthetic resin layer is formed simultaneously with the metallization layer to cover a surface of the metallization layer with a thickness in the range of 5 nm to 1000 nm, preferably 5 nm to 500 nm. The electronic component is electrically connected to the metallization layer. The high-melting-point metallic particles and the low-melting-point metallic particles have a nanocomposite structure.

WO 2013/038817 A1 discloses an electroconductive material having good diffusion of a first metal and a second metal in a soldering step when the material is used, for example, as a solder paste, producing an intermetallic compound having a high melting point at a low temperature and wherein after soldering almost none of the first metal remains. The electroconductive material includes a metal component containing a first metal and a second metal having a higher melting point than the first metal.

US 2012/211549 A1 discloses an electro-conductive bonding material having metalcomponents of a high-melting-point metal particle having a melting point of 150° C or higher;a middle-melting-point metal particle having a melting point between 80° C and 139° C; and a low-melting-point metal particle having a melting point of 79° C or lower, the melting point in the initial state is 79° C. which is the melting point of the low-melting-point metal particle.

US 2010/252616 A1 discloses electrically and thermally conductive compositions forming interconnections between electronic elements. The conductive compositions comprise three or more metal particle types and an organic vehicle comprising a flux. The first particle type includes a reactive high melting point metal which reacts with a reactive low melting point metal of other particles to form intermetallic species. In particular the reactive low melting point metal(s) of the invention are provided in two distinct particle forms. The first reactive low melting point metal particle includes a carrier that facilitates the reaction with the reactive high melting point metal. The second reactive low melting point metal particle acts primarily as a source of the reactive low melting point metal.

### SUMMARY OF THE INVENTION

It is an object of the present invention to provide a functional material which enables a wiring conductor (trace), an electrode, a filling structure, a sealing structure or a bonding structure to be formed without having voids or cracks, and an electronic device employing the same.

It is another object of the present invention to provide a functional material which enables formation of a wiring conductor (trace), an electrode, a filling structure, a sealing structure or a bonding structure that melts at a low temperature but the melting point of which becomes higher after solidification, and an electronic device employing the same.

In order to attain at least one of the above objects, the present invention provides a functional material, a substrate having a trace made of the functional material, and an electronic device employing the substrate.

The functional material according to the present invention is recited in Claim 1.

When the above functional material is used for a trace, an electrode, a filling structure, a sealing structure or a bonding structure, the asymmetry of interdiffusion can be mitigated by a combination of the first, second and third metal composite particles having different melting points T1, T2 and T3, so that the accumulation of atomic vacancies (lattice) can be avoided to suppress the formation of Kirkendall voids. Therefore, it becomes possible to provide a trace, an electrode, a filling structure, a sealing structure or a bonding structure free from Kirkendall voids or the like. In general, the diffusion bond region constitutes a nanocomposite structure having a film thickness or layer thickness of nanometer order (equal to or less than 1µm).

Also, it is possible to set the melting point T3(°C) of the third metal composite particles low and set the melting point T1(°C) of the first metal composite particles high, for example. This enables formation of a trace, an electrode, a filling structure, a sealing structure or a bonding structure that melts at a low temperature but the melting point of which becomes higher after solidification.

Since the first metal composite particles, the second metal composite particles and the third metal composite particles each contain two or more kinds of metal components, the melting points T1, T2 and T3 can be adjusted to satisfy the relationship of T1>T2>T3 by selecting the metal components to be contained.

The functional material according to the present invention may be prepared by dispersing the first metal composite particles, the second metal composite particles and the third metal composite particles in a fluid dispersion medium. Specifically, it may be used as a fluid functional material such as a paste for wiring, filling, an electrode, sealing or bonding.

The present invention also provides an electronic device employing the foregoing functional material. In the present invention, the electronic device may be any type of electrical product based on the technology of electronics. Typical examples include an interposer, various types of semiconductor chips and a three-dimensional system-in-package (3D-SiP).

According to the present invention, as understood from above, the following advantages can be obtained.
(a) It is possible to provide a functional material which enables a wiring conductor (trace), an electrode, a filling structure, a sealing structure or a bonding structure to be formed without having Kirkendall voids or the like, and an electronic device employing the same.
(b) It is possible to provide a functional material which enables formation of a wiring conductor (trace), an electrode, a filling structure, a sealing structure or a bonding structure that melts at a low temperature but the melting point of which becomes higher after solidification, and an electronic device employing the same.

The present invention will be more fully understood from the detailed description given hereinbelow and the accompanying drawings which are given by way of illustration only, and thus not to be considered as limiting the present invention.

### BRIEF DESCRIPTION OF THE DRAWINGS

Fig. 1 is a drawing showing an embodiment of an electronic device employing a functional material according to the present invention.
Fig. 2 is a drawing showing another embodiment of an electronic device employing a functional material according to the present invention.
Fig. 3 is a drawing showing still another embodiment of an electronic device employing a functional material according to the present invention.
Fig. 4 is a drawing showing yet another embodiment of an electronic device employing a functional material according to the present invention.
Fig. 5 is a drawing showing yet another embodiment of an electronic device employing a functional material according to the present invention.
Fig. 6 is an enlarged partial sectional view showing a part of the electronic device in Fig. 5.
Fig. 7 is a drawing showing yet another embodiment of an electronic device employing a functional material according to the present invention.
Fig. 8 is an SEM image of a trace formed with a conventional Sn-Cu conductive paste.
Fig. 9 is an SEM image of a metallization layer formed with a functional material according to the present invention.
Fig. 10 is a drawing showing the results of high temperature shear strength test at 300°C.

### DESCRIPTION OF THE PREFERRED EMBODIMENTS

The functional material according to the present invention takes the form of powder including first metal composite particles, second metal composite particles and third metal composite particles. However, available components are not limited to the three kinds of particles, i.e., the first to third metal composite particles, and it may contain four or more kinds of metal particles or metal composite particles.

The first metal composite particles, the second metal composite particles and the third metal composite particles each contain two or more kinds of metal components. The first to third metal composite particles have a nanocomposite structure. The nanocomposite structure refers to a structure in which crystals or amorphous bodies of metal/alloy or compounds thereof are integrated and combined in nanometer order. The particle shape of the first to third metal composite particles may be uniform or irregular. Also, they may take any shape such as a spherical shape, a scale shape or a flattened shape.

In the functional material according to the present invention, the first to third metal composite particles are different in composition from each other so that the melting points T1(°C), T2(°C) and T3(°C) satisfy the relationship of T1>T2>T3.

Specific examples of the first to third metal composite particles are as follows.

### 1. First Metal Composite Particle

Specifically, the first metal composite particles contain Cu and at least one element selected from the group consisting of Si, B, Ti, Al and Ag. The composition ratio of the components is set within the following range.
Cu: 99.9 wt% or less
Sn: 50 wt% or less
Si, B, Ti, Al and Ag: 0.01 wt% or less

Particles of Cu or an alloy thereof are preferably coated with an oxidation-inhibiting film. A suitable oxidation-inhibiting film is a plating formed by plating the particles of Cu or an alloy thereof with Ag or Sn. Alternatively, they may be coated with a resin that sublimes at 150°C or more.

### 2. Second Metal Composite Particle

Specifically, the second metal composite particles contain Sn, Cu and at least one element selected from the group consisting of Si, B, Ti, Al and Ag. The composition ratio of the components may be set within the following range.
Sn: 98 wt% or less
Cu: 30 wt% or less
Si, B, Ti, Al and Ag: 0.01 wt% or less

### 3. Third Metal Composite Particle

(1) As one option, the third metal composite particles may contain Sn, Bi, Ga and at least one element selected from the group consisting of Si, B, Ti, Al and Ag. In this case, the composition ratio of the components is set within the following range.
   Sn: 40 to 80 wt%
   Bi: 15 to 60 wt%
   Ga: 0.1 wt% or less
   Al: 1 wt% or less
   Si, B, Ti and Ag: 0.01 wt% or less
(2) As another option, the third metal composite particles may contain Sn, Bi, In, Sb and at least one element selected from the group consisting of Ga, Si, B, Ti, Al and Ag. In this case, the composition ratio of the components is set within the following range.
   In: 20 wt% or less with respect to Sn
   Bi: 20 wt% or less with respect to Sn
   Sb: 20 wt% or less with respect to Sn
   Ga, Si, B, Ti, Al and Ag: 1 wt% or less

In the above cases, the melting points T1, T2 and T3 are as follows.
T1 = 1100°C to 500°C
T2 = 400°C to 250°C
T3 = 250°C or less

The functional material contains at least two kinds of particles selected from the first to third metal composite particles; it is not required to contain all three kinds of particles. For example, it may a combination of the first metal composite particles having Cu as a main component and the second metal composite particles having Sn as a main component or a combination of the first metal composite particles and the third metal composite particles having Sn as a main component.

The functional material according to the present invention may be prepared by dispersing the first metal composite particles, the second metal composite particles and the third metal composite particles in a fluid dispersion medium. As the fluid dispersion medium, there may be used various types of organic binders, aqueous dispersion mediums or volatile organic dispersion mediums. Since various types of such dispersion mediums have been known in the art, the most suitable one should be chosen. Specifically, the fluid functional material may be used as a conductive paste for wiring, a paste for filling, a paste for an electrode, a paste for sealing or a paste for bonding.

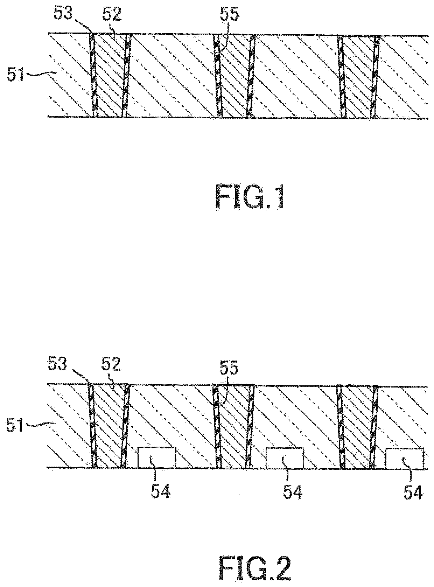

The foregoing functional material according to the present invention may be used for various types of electronic devices as a material for wiring, a material for an electrode, a material for filling, a material for bonding or a material for sealing. Hereinbelow, specific examples will be described with reference to Figs. 1 to 7.

At first, Fig. 1 shows an electronic device in which columnar conductors 52 are disposed in a substrate 51. Typically, the electronic device shown in Fig. 1 may be an interposer. Alternatively, it may be a semiconductor chip in which semiconductor circuit elements 54 are additionally formed in the substrate 51, as shown in Fig. 2. For example, such a semiconductor chip may be a memory chip or a logic chip.

In Figs. 1 and 2, the substrate 51 may be a semiconductor substrate such as Si substrate, SiC substrate or SOI substrate. Also, it may be an inorganic or organic insulating substrate, a dielectric substrate, a magnetic substrate or a composite substrate thereof. For example, the substrate 51 has a thickness of tens of micrometers.

The columnar conductor 52 is disposed in a vertical hole 55 passing through the substrate 51 in the thickness direction. For example, the vertical hole 55 and the columnar conductor 52 may have a diameter of, but not limited to, 60 *µ* m or less. The diameter may further be reduced to 10 *µ* m or less.

The columnar conductor 52 is electrically insulated from the substrate 51, which is a semiconductor substrate such as Si substrate, by an electrical insulating layer 53 provided on the inner wall surface of the vertical hole 55.

The electrical insulating layer 53 may be an oxide or nitride film formed by modifying the inner wall surface of the vertical hole 55 or an insulating layer made of an inorganic functional material, an organic functional material or a combination thereof filled into the vertical hole 55. When the electrical insulating layer 53 is an inorganic insulating layer, specifically, it may be formed such that an insulating paste containing insulating particles, Si particles and an organic Si compound is filled into the vertical holes 55 and hardened. In the process of forming the electrical insulating layer 53, the organic Si compound is reacted with the Si particles inside the vertical holes 55 to form Si-O bond network filling up the space around the insulating particles. Preferably, the reaction between the organic Si compound and the Si particles is allowed to proceed under vacuum while being heated, for example, within a temperature range of 130°C to 150°C.

The columnar conductor 52 is made of the functional material according to the present invention. In the case of Fig. 1, the molten metals are filled into the vertical hole 55. Preferably, filling is performed under a reduced-pressure atmosphere within a vacuum chamber. It is also possible to adopt a differential pressure filling process, wherein the internal pressure of the vacuum chamber is increased after the pressure reduction.

Then, the molten metals filled in the vertical holes 55 are solidified under pressure. This makes it possible to form a high-quality conductive path free from gaps or voids. The columnar conductor 52 may also be formed with a disperse functional material prepared by dispersing the functional material according to the present invention in a dispersion medium.

When the columnar conductor 52 is made of the functional material according to the present invention, the asymmetry of interdiffusion can be mitigated by a combination of at least two kinds of particles selected from the first, second and third metal composite particles having different compositions and melting points T1, T2 and T3, so that the accumulation of atomic vacancies (lattice) can be avoided to suppress the formation of Kirkendall voids. Thus, the columnar conductor 52 free from Kirkendall voids or the like can be formed.

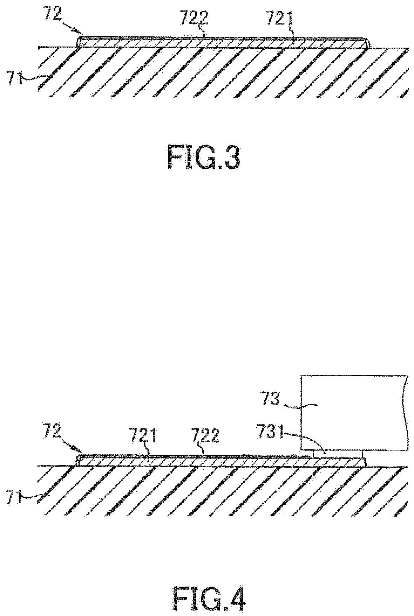

Fig. 3 shows an electronic device in which a planar trace 72 in a predetermined pattern is formed on one surface of a substrate 71. The trace 72 includes a metallization layer 721 and a synthetic resin film 722. In the metallization layer 721, metal components are diffusion bonded to each other. The diffusion bonding may be liquid-phase diffusion bonding or solid-phase diffusion bonding; the choice depends on the process employed.

The metallization layer 721 is covered with the synthetic resin film 722. Depending on its thickness, the synthetic resin film 722 serves as an insulating film or a protective film that is poor in insulation. The synthetic resin film 722 may be made of a photosensitive resin.

The metallization layer 721 contains the first metal composite particles, the second metal composite particles and the third metal composite particles. The first to third metal composite particles each contain two or more kinds of metal components, as described above. The melting points T1, T2 and T3 can be adjusted to satisfy the relationship of T1>T2>T3 by selecting the metal components to be contained.

In the metallization layer 721 of the trace 72, the metal components contained in the first metal composite particles, the second metal composite particles and the third metal composite particles can be diffusion bonded to each other without forming Kirkendall voids. Therefore, an electronic device can be provided with the metallization layer 721 free from voids, cracks and disconnection.

Moreover, since the metallization layer 721 becomes a continuous layer free from voids, cracks and disconnection, the density and compactness of the metallization layer 721 can be increased. Therefore, an electronic device can be provided with the metallization layer 721 having a high electrical conductivity and high mechanical and physical strength.

Furthermore, since the metallization layer 721 is covered with the synthetic resin film 722, the metallization layer 721 can be prevented from being externally damaged and can also be improved in oxidation resistance, durability and weather resistance. Still furthermore, since the synthetic resin film 722 has adhesion strength and bond strength to the substrate 71 in addition to adhesion strength and bond strength of the metallization layer 721 itself, the whole metallization trace can be improved in adhesion strength and bond strength.

In mounting an electronic component, as shown in Fig. 4, an external conductor or an electrode 731 of an electronic component 73 is connected to the metallization trace 72. Outside the connecting part, the metallization layer 721 remains covered with the synthetic resin film 722, so that the antioxidant effect due to the synthetic resin film 722 will not be impaired. This makes it possible to realize a metallization trace that has high reliability in electrical connection of the external conductor and the electronic component 73 to the metallization layer 721 and also has an antioxidant effect on the metallization layer 721.

Preferably, the synthetic resin film 722 is formed at the same time as the metallization layer 721. In this case, unlike in the case where the metallization layer 721 and the resin layer are formed at different times, the metallization layer 721 will not be exposed to air. Therefore, an electronic device can be provided with the high-quality metallization layer 721 that will not suffer from oxidation.

As a means for forming the synthetic resin film 722 and the metallization layer 721 at one time, a conductive paste in which the first, second and third metal composite particles are mixed with an organic binder of synthetic resin and a solvent may be applied to the substrate 71 in a predetermined pattern by using a printing technology and then subjected to a heat treatment. With this heat treatment, the first, second and third metal composite particles are melted in the chain reaction process and diffusion bonded together. The metallization layer 721 is formed by this diffusion bonding. The metallization layer 721 sinks below the synthetic resin film 722 because of the difference in specific gravity. Thus, there is formed the metallization trace 72, in which the outer surface of the metallization layer 721 adhered to the substrate 71 is covered with the synthetic resin film 722. The synthetic resin film 722 may have a thickness suitable for serving as an insulating film or a small thickness so as to put a higher priority on the antioxidant effect than on the insulation effect.

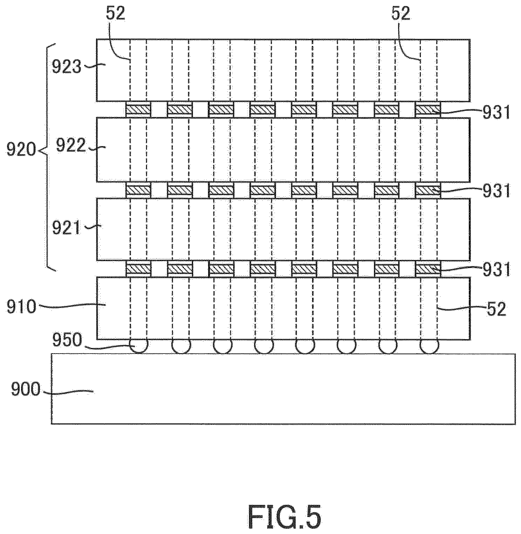

Fig. 5 shows a three-dimensional electronic device in which a stack 920 including a plurality of semiconductor chips 921 to 923 is mounted on an interposer 910 according to the present invention and the interposer 910 is mounted on a motherboard 900. Columnar conductors 52 in the interposer 910 and the semiconductor chips 921 to 923 are bonded through a bonding material 931. The interposer 910 is bonded to the motherboard 900 through a ball grid 950 or the like.

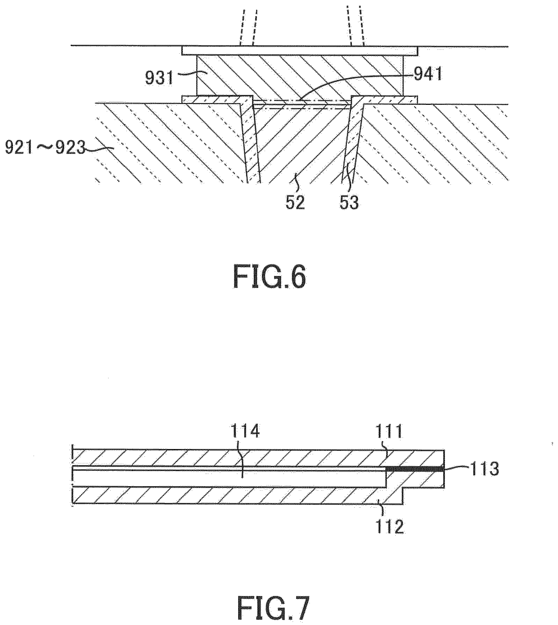

The bonding material 931 can be made of the functional material according to the present invention. Preferably, a nanocomposite brazing alloy or nanocomposite particles are employed as the bonding material 931. Then, as shown in Fig. 6 on an enlarged scale, one end of the columnar conductor 52 is liquid-phase or solid-phase diffusion bonded (indicated by 941) to another conductor, i.e., another columnar conductor 52 through the bonding material 931. Although not shown in the drawings, the diffusion bonding between the columnar conductor of Figs. 1 and 2 and the metallization layer of Figs. 3 and 4 may also be performed by the above-mentioned liquid-phase or solid-phase diffusion bonding.

Typically, the semiconductor chips 921 to 923 may be a memory chip or a logic chip. They may also be a system LSI, a memory LSI, an image sensor, a MEMS, an electronic device including an analog or digital circuit, a logic circuit such as CPU or the like, or an electronic device that is produced by preparing different types of circuits such as an analog high frequency circuit and a low frequency, low power consumption circuit in different processes and stacking them. Furthermore, they may be selected from most of electronic devices having an electronic circuit as a functional element, such as a sensor module, an optoelectronic module, a unipolar transistor, a MOS FET, a CMOS FET, a memory cell, integrated circuits (IC) thereof, or various scales of LSIs.

On the other hand, Fig. 7 shows an embodiment in which the functional material according to the present invention is used as a sealing material. Fig. 7 shows an electronic device of, for example, a liquid crystal display, in which the outer edge at which a front panel 111 and a rear panel 112 are opposed to each other is sealed by a sealing layer 113, so that the internal space 114 between the front panel 111 and the rear panel 112 is secluded from the outside. The sealing layer 113 is made of the functional material according to the present invention. Thus, the sealing layer 113 can serve not only the essential sealing function such as airtightness and watertightness but also other functions such as electromagnetic shield and electrostatic shield.

In the foregoing embodiments shown in Figs. 1 to 7, the functional material according to the present invention is used as the columnar conductor 52 (Figs. 1 and 2), the metallization layer 721 (Figs. 3 and 4), the bonding material 931 (Figs. 5 and 6) and the sealing material 113 (Fig. 7). When the functional material according to the present invention is used, the asymmetry of interdiffusion due to a difference between the melting point T1(°C) of the first metal composite particles and the melting point T3(°C) of the third metal composite particles can be mitigated by the second metal composite particles having the intermediate melting point T2(°C), so that the accumulation of atomic vacancies (lattice) can be avoided to suppress the formation of Kirkendall voids.

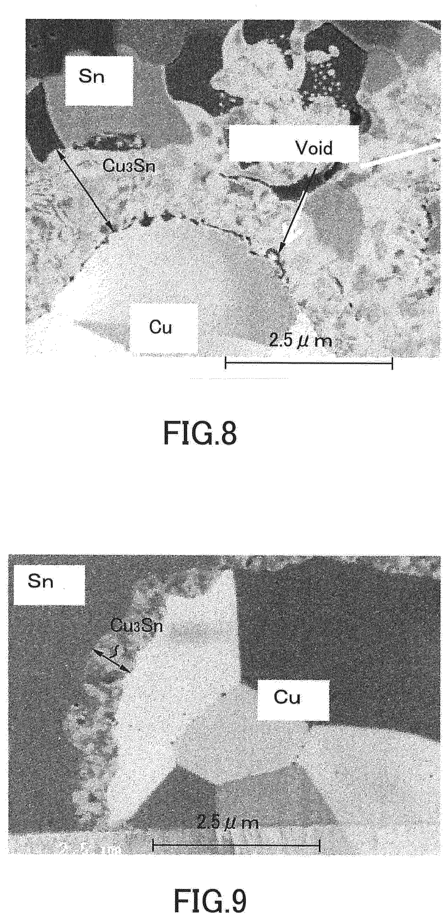

In this regard, description will be made with reference to SEM (scanning electron microscope) images shown in Figs. 8 and 9. Fig. 8 shows the SEM image of a trace made of a conventional Sn-Cu conductive paste, while Fig. 9 shows the SEM image of a metallization layer (Figs. 3 and 4) made of the functional material according to the present invention.

Referring first to Fig. 8 showing the SEM image of the trace made of the conventional Sn-Cu conductive paste, the diffusion layer of Cu₃Sn exists at the interface between the Cu crystal and the Sn crystal, and the voids are formed almost all along the interface between the Cu₃Sn layer and the Cu crystal.

Referring to Fig. 9, on the other hand, the diffusion layer of Cu₃Sn formed at the interface between the Cu crystal grain and the Sn crystal grain in the metallization layer made of the functional material according to the present invention has a shape in conformity with the shape of the crystal grains, joining to the Cu crystal grain and the Sn crystal grain without having voids therebetween. As one characteristic feature, the diffusion layer of Cu₃Sn constitutes a nanocomposite structure having a layer thickness of 700 nm or less. It should be noted that in Fig. 9, the difference in image color within the Cu crystal grain region comes from the difference in crystal orientation.

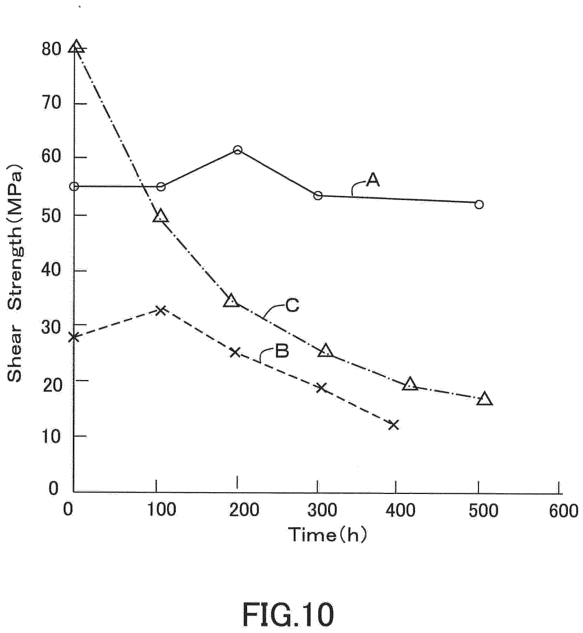

Moreover, when tested for high temperature shear strength, the metallization layer made of the functional material according to the present invention exhibits a high retention reliability at high temperature. In this regard, description will be made with reference to Fig. 10. Fig. 10 is a drawing showing the results of high temperature shear strength test at 300°C, wherein time (h) is plotted in abscissa and shear strength (MPa) is plotted in ordinate. The curve A represents the shear strength characteristic of a metallization layer (Figs. 3 and 4) made of the functional material according to the present invention; the curve B represents the shear strength characteristic of a trace made of a conductive paste disclosed in Japanese Patent No. 3869859; the curve C represents the shear strength characteristic of a conventional trace made of an Au-12Ge conductive paste.

At first, as indicated by the curve B, the shear strength of the trace made of the conductive paste disclosed in Japanese Patent No. 3869859 is as low as 30 (MPa) at the beginning and drops to 10 (MPa) at 400 hours.

Then, as indicated by the curve C, the shear strength of the conventional trace made of the Au-12Ge conductive paste is as high as 80 (MPa) at the beginning but rapidly decreases over time and drops to about 20 (MPa) at 500 hours.

On the other hand, as indicated by the curve A, the shear strength of the metallization layer made of the functional material according to the present invention is as high as 57 (MPa) at the beginning and remains about the same at 500 hours.

From the above, it is understood that since the metallization layer made of the functional material according to the present invention becomes a continuous layer free from voids, cracks and disconnection, the density and compactness of the metallization layer can be increased. Therefore, the metallization layer can be provided with a high electrical conductivity and high mechanical and physical strength.

Since Figs. 8 to 10 illustrate the properties of the functional material according to the present invention itself, the experimental data in Figs. 8 to 10 is also applicable to the columnar conductor (Figs. 1 and 2), the bonding material (Figs. 5 and 6) and the sealing material (Fig. 7) made of the same functional material.

Inside the columnar conductor 52 shown in Figs. 1 and 2, accordingly, the diffusion layer of Cu₃Sn formed at the interface between the Cu crystal grain and the Sn crystal grain has a shape in conformity with the shape of the crystal grains, joining to the Cu crystal grain and the Sn crystal grain without having voids therebetween, as shown in Fig. 9.

## Claims

1. A functional material comprising first metal composite particles, second metal composite particles and third metal composite particles,
each of the first metal composite particles, the second metal composite particles and the third metal composite particles containing two or more kinds of metal components having a predetermined composition ratio,
the melting point T1(°C) of the first metal composite particles, the melting point T2(°C) of the second metal composite particles and the melting point T3(°C) of the third metal composite particles satisfying a relationship of T1>T2>T3,
**characterized in that**:
the first metal composite particles, second metal composite particles and third metal composite particles have a nanocomposite structure in which crystals or amorphous bodies of metal/alloy or compounds thereof are integrated and combined in nanometer order,
the first metal composite particles contain Cu and at least one element selected from the group consisting of Si, B, Ti, Al and Ag, wherein a composition ratio of the elements of the first metal composite particles is set at 99.9 wt% or less Cu, 50 wt% or less Sn, and 0.01 wt% or less Si, B, Ti, Al and Ag,
the second metal composite particles contain Sn, Cu and at least one element selected from the group consisting of Si, B, Ti, Al and Ag, wherein a composition ratio of the elements of the second metal composite particles is set at 98 wt% or less Sn, 30 wt% or less Cu, and 0.01 wt% or less Si, B, Ti, Al and Ag,
the third metal composite particles contain:
• Sn, Bi, Ga and at least one element selected from a group consisting of Si, B, Ti, Al and Ag, a composition ratio of the elements of the third metal composite particles is set at 40 to 80 wt% Sn, 15 to 60 wt% Bi, 0.1 wt% or less Ga, 1 wt% or less Al, and 0.01 wt% or less of the at least one element selected from the group consisting of Si, B, Ti and Ag; or
• Sn, Bi, In, Sb and at least one element selected from a group consisting of Ga, Si, B, Ti, Al and Ag, a composition ratio of the elements of the third metal composite particles is set at 20 wt% or less In with respect to Sn, 20 wt% or less Bi with respect to Sn, 20 wt% or less Sb with respect to Sn, and 1 wt% or less Ga, Si, B, Ti, Al and Ag,
wherein the melting points T1, T2 and T3 are selected from following ranges:
T1 = 1100°C to 500°C,
T2 = 400°C to 250°C, and
T3 = 250°C or less,
and wherein the second metal composite particles having an intermediate melting point T2 are configured to mitigate asymmetry of interdiffusion due to a difference between the melting point of the first metal composite particles and the melting point of the third metal composite particles so that an accumulation of atomic vacancies is avoided to suppress a formation of Kirkendall voids.

2. The functional material of Claim 1, wherein the first metal composite particles, the second metal composite particles and the third metal composite particles are dispersed in a fluid dispersion medium.

3. An electronic device comprising a semiconductor substrate (51) and a columnar conductor (52), the columnar conductor (52) being made of the functional material of Claim 1 and embedded in the semiconductor substrate (51) in an electrically insulated state.

4. The electronic device of Claim 3, further comprising an electronic element, wherein the electronic element is a wiring conductor, another electronic device or an electronic component, a conductive part of which is at least partially diffusion bonded to at least one of opposite ends of the columnar conductor.

5. The electronic device of Claim 4, wherein another conductor is liquid-phase or solid-phase diffusion bonded to at least one of opposite ends of the columnar conductor (52) with a nanocomposite brazing alloy or nanocomposite particles.

## Patentansprüche

1. Funktionelles Material, umfassend erste Metallverbundpartikel, zweite Metallverbundpartikel und dritte Metallverbundpartikel, wobei jedes der ersten Metallverbundpartikel, der zweiten Metallverbundpartikel und der dritten Metallverbundpartikel zwei oder mehr Arten von Metallkomponenten enthält, die ein vorbestimmtes Zusammensetzungsverhältnis aufweisen, wobei der Schmelzpunkt T1(°C) der ersten Metallverbundpartikel, der Schmelzpunkt T2(°C) der zweiten Metallverbundpartikel und der Schmelzpunkt T3(°C) der dritten Metallverbundpartikel eine Beziehung T1 >T2>T3 erfüllen, **dadurch gekennzeichnet, dass**:
die ersten Metallverbundpartikel, zweiten Metallverbundpartikel und dritten Metallverbundpartikel eine Nanoverbundstruktur aufweisen, in der Kristalle oder amorphe Körper aus Metall/Legierung oder Verbindungen davon integriert und in Nanometerordnung kombiniert sind, die ersten Metallverbundpartikel Cu und mindestens ein Element enthalten, das aus der Gruppe ausgewählt ist, die aus Si, B, Ti, Al und Ag besteht, wobei ein Zusammensetzungsverhältnis der Elemente der ersten Metallverbundpartikel auf 99,9 Gew.-% oder weniger Cu, 50 Gew.-% oder weniger Sn und 0,01 Gew.-% oder weniger Si, B, Ti, Al und Ag festgesetzt ist, wobei die zweiten Metallverbundpartikel Sn, Cu und mindestens ein Element enthalten, das aus der Gruppe ausgewählt ist, die aus Si, B, Ti, Al und Ag besteht, wobei ein Zusammensetzungsverhältnis der Elemente der zweiten Metallverbundpartikel auf 98 Gew.-% oder weniger Sn, 30 Gew.-% oder weniger Cu und 0,01 Gew.-% oder weniger Si, B, Ti, Al und Ag festgesetzt ist,
die dritten Metallverbundpartikel Folgendes enthalten:
• Sn, Bi, Ga und mindestens ein Element, das aus der Gruppe ausgewählt ist, die aus Si, B, Ti, Al und Ag besteht, wobei ein Zusammensetzungsverhältnis der Elemente der dritten Metallverbundpartikel auf 40 bis 80 Gew.-% Sn, 15 bis 60 Gew.-% Bi, 0,1 Gew.-% oder weniger Ga, 1 Gew.-% oder weniger Al und 0,01 Gew.-% oder weniger des mindestens einen Elements festgesetzt ist, das aus der Gruppe ausgewählt ist, die aus Si, B, Ti und Ag besteht; oder
• Sn, Bi, In, Sb und mindestens ein Element, das aus einer Gruppe ausgewählt ist, die aus Ga, Si, B, Ti, Al und Ag besteht, wobei ein Zusammensetzungsverhältnis der Elemente der dritten Metallverbundpartikel auf 20 Gew.-% oder weniger In in Bezug auf Sn, 20 Gew.-% oder weniger Bi in Bezug auf Sn, 20 Gew.-% oder weniger Sb in Bezug auf Sn und 1 Gew.-% oder weniger Ga, Si, B, Ti, Al und Ag festgesetzt ist,
wobei die Schmelzpunkte T1, T2 und T3 aus folgenden Bereichen ausgewählt sind:
T1 = 1100 °C bis 500 °C,
T2 = 400 °C bis 250 °C, und
T3 = 250 °C oder weniger,
und wobei die zweiten Metallverbundpartikel, die einen mittleren Schmelzpunkt T2 aufweisen, konfiguriert sind, um eine Asymmetrie der Interdiffusion aufgrund eines Unterschieds zwischen dem Schmelzpunkt der ersten Metallverbundpartikel und dem Schmelzpunkt der dritten Metallverbundpartikel zu mildern, sodass eine Anhäufung von atomaren Leerstellen vermieden wird, um eine Bildung von Kirkendall-Löchern zu unterdrücken.

2. Funktionelles Material nach Anspruch 1, wobei die ersten Metallverbundpartikel, die zweiten Metallverbundpartikel und die dritten Metallverbundpartikel in einem Fluiddispersionsmedium dispergiert sind.

3. Elektronische Vorrichtung, umfassend ein Halbleitersubstrat (51) und einen säulenförmigen Leiter (52), wobei der säulenförmige Leiter (52) aus dem Funktionsmaterial nach Anspruch 1 hergestellt und in einem elektrisch isolierten Zustand in das Halbleitersubstrat (51) eingebettet ist.

4. Elektronische Vorrichtung nach Anspruch 3, ferner umfassend ein elektronisches Element, wobei das elektronische Element ein Verdrahtungsleiter, eine andere elektronische Vorrichtung oder eine elektronische Komponente ist, von der ein leitender Teil mindestens teilweise durch Diffusion mit mindestens einem der gegenüberliegenden Enden des säulenförmigen Leiters verbunden ist.

5. Elektronische Vorrichtung nach Anspruch 4, wobei ein anderer Leiter eine Flüssigphasen- oder Festphasendiffusion ist, die mit mindestens einem der gegenüberliegenden Enden des säulenförmigen Leiters (52) mit einem Nanoverbundhartlot oder Nanoverbundpartikel verbunden ist.

## Revendications

1. Matériau fonctionnel comprenant des premières particules composites métalliques, des deuxièmes particules composites métalliques et des troisièmes particules composites métalliques,
chacune des premières particules composites métalliques, des deuxièmes particules composites métalliques et des troisièmes particules composites métalliques contenant au moins deux types de composants métalliques ayant un rapport de composition prédéterminé,
le point de fusion T1 (°C) des premières particules composites métalliques, le point de fusion T2 (°C) des deuxièmes particules composites métalliques et le point de fusion T3 (°C) des troisièmes particules composites métalliques satisfaisant une relation de T1 > T2 > T3,
**caractérisé en ce que** :
les premières particules composites métalliques, les deuxièmes particules composites métalliques et les troisièmes particules composites métalliques ont une structure nanocomposite dans laquelle des cristaux ou des corps amorphes de métal/alliage ou des composés de ceux-ci sont intégrés et combinés dans l'ordre nanométrique,
les premières particules composites métalliques contiennent du Cu et au moins un élément choisi parmi le groupe constitué de Si, B, Ti, Al et Ag, un rapport de composition des éléments des premières particules composites métalliques étant fixé à 99,9 % en poids ou moins de Cu, 50 % en poids ou moins de Sn et 0,01 % en poids ou moins de Si, B, Ti, Al et Ag,
les deuxièmes particules composites métalliques contiennent du Sn, Cu et au moins un élément choisi parmi le groupe constitué de Si, B, Ti, Al et Ag, un rapport de composition des éléments des deuxièmes particules composites métalliques étant fixé à 98 % en poids ou moins de Sn, 30 % en poids ou moins de Cu et 0,01 % en poids ou moins de Si, B, Ti, Al et Ag,
les troisièmes particules métalliques composites contiennent :
• du Sn, Bi, Ga et au moins un élément choisi parmi le groupe constitué de Si, B, Ti, Al et Ag, un rapport de composition des éléments des troisièmes particules composites métalliques étant fixé à 40 à 80 % en poids de Sn, 15 à 60 % en poids de Bi, 0,1 % en poids ou moins de Ga, 1 % en poids ou moins d'Al et 0,01 % en poids ou moins de l'au moins un élément choisi parmi le groupe constitué de Si, B, Ti et Ag ; ou
• du Sn, Bi, In, Sb et au moins un élément choisi parmi le groupe constitué de Ga, Si, B, Ti, Al et Ag, un rapport de composition des éléments des troisièmes particules composites métalliques étant fixé à 20 % en poids ou moins d'In par rapport au Sn, 20 % en poids ou moins de Bi par rapport au Sn, 20 % en poids ou moins de Sb par rapport au Sn, et 1 % en poids ou moins de Ga, Si, B, Ti, Al et Ag,
les points de fusion T1, T2 et T3 étant choisis parmi les plages suivantes :
T1 = 1 100 °C à 500 °C,
T2 = 400 °C à 250 °C, et
T3 = 250 °C ou moins,
et les deuxièmes particules métalliques composites ayant un point de fusion intermédiaire T2 étant conçues pour atténuer l'asymétrie d'interdiffusion due à une différence entre le point de fusion des premières particules composites métalliques et le point de fusion des troisièmes particules composites métalliques de sorte qu'une accumulation de lacunes atomiques est évitée afin de supprimer une formation de vides de Kirkendall.

2. Matériau fonctionnel selon la revendication 1, les premières particules composites métalliques, les deuxièmes particules composites métalliques et les troisièmes particules composites métalliques étant dispersées dans un milieu de dispersion fluide.

3. Dispositif électronique comprenant un substrat semi-conducteur (51) et un conducteur colonnaire (52), le conducteur colonnaire (52) étant constitué du matériau fonctionnel selon la revendication 1 et incorporé dans le substrat semi-conducteur (51) dans un état électriquement isolé.

4. Dispositif électronique selon la revendication 3, comprenant en outre un élément électronique, l'élément électronique étant un conducteur de câblage, un autre dispositif électronique ou un composant électronique, dont une partie conductrice est au moins partiellement liée par diffusion à au moins une des extrémités opposées du conducteur colonnaire.

5. Dispositif électronique selon la revendication 4, un autre conducteur étant une diffusion en phase liquide ou en phase solide liée à au moins l'une des extrémités opposées du conducteur colonnaire (52) avec un alliage de brasage nanocomposite ou des particules nanocomposites.
